# EUROPEAN PATENT SPECIFICATION

(11) **EP 4 012 758 B1**
(45) Date of publication and mention of the grant of the patent: **20.12.2023**
(21) Application number: 21770111.9
(22) Date of filing: 28.05.2021
(51) Int. Cl.: H10B 12/00

(54) **SEMICONDUCTOR DEVICE AND MANUFACTURING METHOD THEREFOR**
HALBLEITERBAUELEMENT UND HERSTELLUNGSVERFAHREN DAFÜR
DISPOSITIF À SEMI-CONDUCTEUR ET SON PROCÉDÉ DE FABRICATION

(30) Priority: 16.10.2020 CN 202011107711
(43) Date of publication of application: 15.06.2022
(73) Proprietor: Changxin Memory Technologies, Inc., Hefei City, Anhui 230000 (CN)
(72) Inventor: ZHU, Xiao, Hefei City, Anhui 230000 (CN)
(74) Representative: Lavoix
(86) International application number: PCT/CN2021/096858
(87) International publication number: WO 2022/077919

(56) References cited:
- CN-A- 1 238 556
- CN-A- 1 790 722
- CN-A- 1 815 718
- US-A1- 2002 187 606
- US-A1- 2015 132 942
- US-A1- 2016 118 247
- US-A1- 2020 273 862

## Description

### CROSS-REFERENCE TO RELATED APPLICATION

This application claims priority to Chinese patent application No. 202011107711.0, filed to the China national intellectual property administration on October 16, 2020 and entitled "Semiconductor device and manufacturing method thereof'.

### TECHNICAL FIELD

The disclosure relates to the field of semiconductor manufacturing technologies, and in particular to a semiconductor device and a semiconductor device manufacturing method.

### BACKGROUND

A dynamic random access memory (DRAM) is a semiconductor memory for writing and reading data at high speed and randomly, and is widely used in data storage equipment or device.

In the DRAM, a capacitor array structure includes multiple capacitor contact holes. The multiple capacitor contact holes are usually arranged in an array, and a capacitor structure is arranged in it. Effective isolation is required between the adjacent capacitor contact holes. However, with the continuous decrease of a feature size of a DRAM device, the present thickness of an isolating gate is close to the limit of the quantum tunneling effect, and the inductive coupling effect between the adjacent capacitor contact holes increases, which affects the storage stability of a semiconductor memory.

US 20160118247 A1 relates to a method of forming a semiconductor device.

US 20150132942 A1 relates to a method of manufacturing a semiconductor device.

US 20200273862 A1 relates to a semiconductor memory device and a manufacturing method thereof.

### SUMMARY

To solve at least one of the problems mentioned in the background technology, the disclosure provides a semiconductor device and a semiconductor device manufacturing method, which can reduce the inductive coupling effect between the storage node contact structures, improve the charge storage capacity of the semiconductor device, and optimize the storage stability and reliability of the semiconductor device.

A semiconductor device according to the invention is presented in claim 1 and a semiconductor device manufacturing method according to the invention in claim 7. Embodiments of the invention are presented in the dependent claims.

To achieve the purpose, in the first aspect, the disclosure provides a semiconductor device, which includes a substrate, multiple isolating gate structures and a storage node contact structure. Multiple bit lines are arranged at intervals along a first direction on the substrate. The multiple isolating gate structures are located between the adjacent bit lines and arranged on the substrate at intervals along a second direction. The storage node contact structure is located between the adjacent isolating gate structures, and a bottom of the storage node contact structure extends into the substrate. The isolating gate structure includes a first isolating part and a second isolating part, the first isolating part surrounds the second isolating part. A top surface of the first isolating part is not lower than a top surface of the bit line. The semiconductor device further includes a third dielectric layer formed on a top surface of the second isolating part. The top surface of the second isolating part is lower than the top surface of the first isolating part, a top surface of the third dielectric layer is flush with the top surface of the first isolating part and materials of the second isolating part and the third dielectric layer are different.

In the semiconductor device provided by the disclosure, by arranging multiple isolating gate structures between the adjacent bit lines, the memory node contact structure between the adjacent isolating gate structures is separated by the multiple isolating gate structures. By setting the isolating gate structure to the first isolating part and the second isolating part, the first isolating part surrounds the second isolating part, the isolating gate structure is optimized, the type of isolating medium in the isolating gate structure is increased, and its structure is optimized. By setting the top surface of the first isolating part not lower than the top surface of the bit line, and using the first isolating part to isolate metal layers of the adjacent bit lines, not only the inductive coupling effect between the adjacent storage node contact structures is reduced, but the inductive coupling effect between the metal layers of the adjacent bit lines can also be reduced, thereby ensuring that the inductive coupling effect in the semiconductor device is small after a feature size of a DRAM device continues to decrease, improving the charge storage capacity of the semiconductor device, and optimizing the storage stability and reliability of the semiconductor device.

Optionally, the semiconductor device may also include an insulating dielectric layer on the substrate, and the bottom of the second isolating part may abut against the insulating dielectric layer. Setting like this may avoid the mutual interference of structures between the second isolating part and the substrate and improve the structure stability of the semiconductor device.

Optionally, the semiconductor device may also include a bit line isolating layer, which is located on a side wall and a top surface of the bit line. The bit line isolating layer may isolate the bit line and the storage node contact structure. Setting like this may use the bit line isolating layer to protect the bit line, and at the same time, prevent the bit line from contacting with other structural layers to affect the transmission of a bit line signal.

In the semiconductor device, optionally, materials of the insulating dielectric layer and the bit line isolating layer may be identical or different.

In the semiconductor device, optionally, materials of the second isolating part and the insulating dielectric layer may be identical or different.

In the semiconductor device, optionally, a bottom of the first isolating part may abut against the insulating dielectric layer.

In the second aspect, the disclosure provides a semiconductor device manufacturing method, which includes: providing a substrate; forming multiple bit lines, which are arranged at intervals along a first direction, on the substrate; forming multiple isolating gate structures, which are arranged on the substrate at intervals along a second direction, between the adjacent bit lines; and forming a storage node contact structure, a bottom of which extends into the substrate, between the adjacent isolating gate structures. The isolating gate structure includes a first isolating part and a second isolating part, and the first isolating part surrounds the second isolating part, and a top surface of the first isolating part is not lower than a top surface of the bit line. A top surface of the second isolating part is lower than the top surface of the first isolating part, a third dielectric layer is formed on the top surface of the second isolating part, a top surface of the third dielectric layer is flush with the top surface of the first isolating part and materials of the second isolating part and the third dielectric layer are different.

In the semiconductor device manufacturing method provided by the disclosure, by arranging multiple isolating gate structures between the adjacent bit lines, the memory node contact structure between the adjacent isolating gate structures is separated by the multiple isolating gate structures. By setting the isolating gate structure to the first isolating part and the second isolating part, the first isolating part surrounds the second isolating part, the isolating gate structure is optimized, the type of isolating medium in the isolating gate structure is increased, and its structure is optimized. By setting the top surface of the first isolating part not lower than the top surface of the bit line, and using the first isolating part to isolate metal layers of the adjacent bit lines, not only the inductive coupling effect between the adjacent storage node contact structures is reduced, but the inductive coupling effect between the metal layers of the adjacent bit lines can also be reduced, thereby ensuring that the inductive coupling effect in the semiconductor device is small after a feature size of a DRAM device continues to decrease, improving the charge storage capacity of the semiconductor device, and optimizing the storage stability and reliability of the semiconductor device.

In the semiconductor device manufacturing method, optionally, before the multiple bit lines, which are arranged at intervals along the first direction, are formed on the substrate, the method may further include: an insulating dielectric layer is formed on the substrate; and after the multiple bit lines, which are arranged at intervals along the first direction, are formed on the substrate, and before the multiple isolating gate structures, which are arranged on the substrate at intervals along the second direction, are formed between the adjacent bit lines, the method may further include: a bit line isolating layer is formed on a side wall and the top surface of the bit line.

Setting like this may use the insulating dielectric layer to avoid mutual effect between the bit line and the bit line isolating layer and the substrate structure.

In the semiconductor device manufacturing method, optionally, the operation that the multiple isolating gate structures, which are arranged on the substrate at intervals along the second direction, are formed between the adjacent bit lines may specifically include: a sacrificial dielectric layer is formed between the adjacent bit lines; the sacrificial dielectric layer is patterned along the second direction, and trenches, which are arranged at intervals along the second direction and expose the insulating dielectric layer, are formed between the adjacent bit lines; and the first isolating part is formed on at least part of a side wall of the trench, the second isolating part is formed in the trench, and the first isolating part and the second isolating part form the isolating gate structure.

Setting like this may use the sacrificial dielectric layer to form a mask structure, which facilitates the formation of the trench and the arrangement of the isolating gate structure in the trench.

In the semiconductor device manufacturing method, optionally, the operation that the first isolating part is formed on at least part of the side wall of the trench, the second isolating part is formed in the trench, and the first isolating part and the second isolating part form the isolating gate structure may specifically include: a first dielectric layer is formed on at least part of the side wall of the trench; a second dielectric layer is formed in the trench, and the second dielectric layer is etched back to form the second isolating part; the third dielectric layer is formed on the top surface of the second isolating part in the trench; and the sacrificial dielectric layer, the first dielectric layer and the third dielectric layer are etched back to form the first isolating part having the top surface flushing with the top surface of the third dielectric layer after etching.

By arranging the first dielectric layer, the second dielectric layer and the third dielectric layer, the formation of the first isolating part and the second isolating part is realized.

In the semiconductor device manufacturing method, optionally, the operation that the storage node contact structure, the bottom of which extends into the substrate, is formed between the adjacent isolating gate structures may specifically include: the sacrificial dielectric layer between the adjacent isolating gate structures and the insulating dielectric layer on the substrate are removed, and an opening to expose the substrate is formed between the adjacent isolating gate structures; and the storage node contact structure is formed in the opening.

Setting like this may use the opening to form the storage node contact structure, thereby ensuring that the storage node contact structure is located between the adjacent isolating gate structures, and ensuring the isolation of the storage node contact structure by the isolating gate structure.

The structure of the disclosure and its other inventive purposes and beneficial effects will be more obvious and understandable through a description of the preferred embodiments in combination with the accompanying drawings.

### BRIEF DESCRIPTION OF THE DRAWINGS

In order to more clearly illustrate the technical solution in the embodiment of the disclosure or the related art, the accompanying drawings needed in description of the embodiments or the related art are simply introduced below. It is apparent that the accompanying drawings in the following description are some embodiments of the disclosure, for the ordinary skill in the art, some other accompanying drawings may also be obtained according to these on the premise of not contributing creative effort.
FIG. 1 is a structure diagram of an isolating gate structure in a semiconductor memory in the related art.
FIG. 2 is a partial three-dimensional structure diagram of a semiconductor device provided by an embodiment of the disclosure.
FIG. 3 is a structure diagram of a substrate, an insulating dielectric layer and a sacrificial dielectric layer of a semiconductor device provided by an embodiment of the disclosure.
FIG. 4 is a structure diagram of forming a trench on a sacrificial dielectric layer of a semiconductor device provided by an embodiment of the disclosure.
FIG. 5 is a structure diagram of forming a first dielectric layer in a trench of a semiconductor device provided by an embodiment of the disclosure.
FIG. 6 is a structure diagram of forming a second dielectric layer of a semiconductor device provided by an embodiment of the disclosure.
FIG. 7 is a structure diagram of forming a second isolating part of a semiconductor device provided by an embodiment of the disclosure.
FIG. 8 is a structure diagram of forming a third dielectric layer of a semiconductor device provided by an embodiment of the disclosure.
FIG. 9 is a structure diagram of forming a first isolating part of a semiconductor device provided by an embodiment of the disclosure.
FIG. 10 is a structure diagram of forming an opening of a semiconductor device provided by an embodiment of the disclosure.
FIG. 11 is a structure diagram of forming a storage node contact structure of a semiconductor device provided by an embodiment of the disclosure.
FIG. 12 is a structure diagram of an isolating gate structure of a semiconductor device provided by an embodiment of the disclosure.
FIG. 13 is a flowchart of a semiconductor device manufacturing method provided by an embodiment of the disclosure.
FIG. 14 is a flowchart of forming an insulating dielectric layer and a bit line isolating layer in a semiconductor device manufacturing method provided by an embodiment of the disclosure.
FIG. 15 is a flowchart of forming an isolating gate structure in a semiconductor device manufacturing method provided by an embodiment of the disclosure.
FIG. 16 is a flowchart of forming a first isolating part and a second isolating part in a semiconductor device manufacturing method provided by an embodiment of the disclosure.
FIG. 17 is a flowchart of forming a storage node contact structure in a semiconductor device manufacturing method provided by an embodiment of the disclosure.

### Descriptions about the reference signs:

10-a substrate; 11-an insulating dielectric layer; 20-a bit line; 21-a bit line isolating layer; 22-a sacrificial dielectric layer; 30-an isolating gate structure; 40-a storage node contact structure; 41-a contact plug; 42-a connection pad; 50-a trench; 51-a first dielectric layer; 52-a second dielectric layer; 53-a third dielectric layer; 60-an opening.

### DETAILED DESCRIPTION

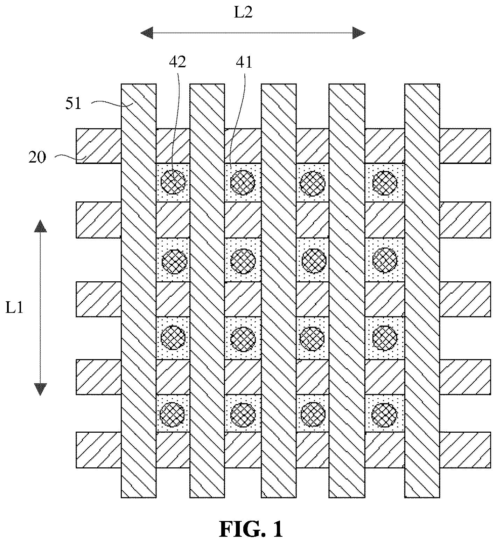

The inventor of the disclosure finds in the actual research process that in the present DRAM, a capacitor array structure includes multiple capacitor contact holes, the multiple capacitor contact holes are usually arranged in an array, and a capacitor structure is arranged in it. FIG. 1 is a structure diagram of an isolating gate structure in a semiconductor memory in the related art. As illustrated in FIG. 1, an isolating gate is arranged between the adjacent capacitor contact holes. The present isolating gate is usually a single-layer isolator, for example, silicon oxide. The isolating gate is configured to isolate the inductive coupling between the adjacent capacitor contact holes. The single-layer oxide structure may be a first dielectric layer 51 in FIG. 1. The first dielectric layer 51 between adjacent bit lines 20 may isolate a contact plug 41 and a connection pad 42 in the adjacent capacitor contact holes. Multiple bit lines 20 are arranged at intervals along a first direction L1, and multiple capacitor contact holes between the bit lines 20 are arranged at intervals along a second direction L2. However, with the continuous decrease of a feature size of a DRAM device, the present thickness of the isolating gate is close to the limit of the quantum tunneling effect, and the inductive coupling effect between the adjacent capacitor contact holes increases, which affects the storage stability of a semiconductor memory.

In view of this, in a semiconductor device manufacturing method provided by the embodiments of the disclosure, by arranging multiple isolating gate structures between the adjacent bit lines of a semiconductor device, a memory node contact structure between the adjacent isolating gate structures is separated by the multiple isolating gate structures. By setting the isolating gate structure to a first isolating part and a second isolating part, the first isolating part surrounds the second isolating part, the isolating gate structure is optimized, the type of isolating medium in the isolating gate structure is increased, and its structure is optimized. By setting a top surface of the first isolating part not lower than a top surface of the bit line, and using the first isolating part to isolate metal layers of the adjacent bit lines, not only the inductive coupling effect between the adjacent storage node contact structures is reduced, but the inductive coupling effect between the metal layers of the adjacent bit lines can also be reduced, thereby ensuring that the inductive coupling effect in the semiconductor device is small after a feature size of a DRAM device continues to decrease, improving the charge storage capacity of the semiconductor device, and optimizing the storage stability and reliability of the semiconductor device.

In order to make the purpose, technical solutions and advantages of the disclosure clearer, the technical solutions in the embodiments of the disclosure will be described below in more detail in combination with the accompanying drawings in the preferred embodiments of the disclosure. In the accompanying drawings, the same or similar reference signs throughout represent the same or similar parts or the parts with the same or similar function. The described embodiments are a part of the embodiments of the disclosure but not all. The embodiments described below by reference to the accompanying drawings are exemplary, and they are intended to explain the disclosure and are not understood as a limit to the disclosure. The embodiments of the disclosure are elaborated below in combination with the accompanying drawings.

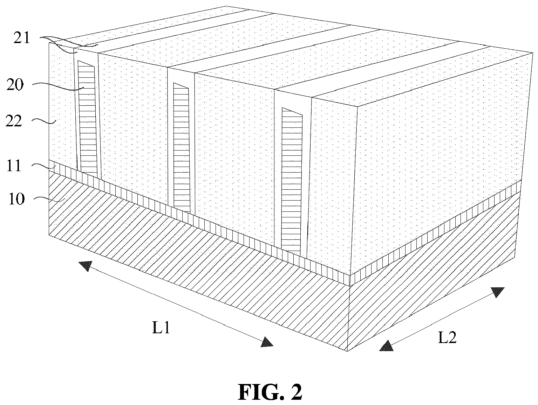

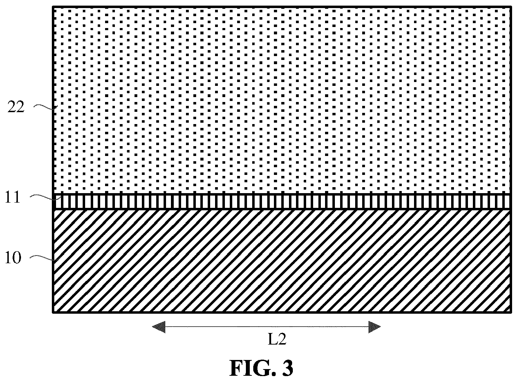

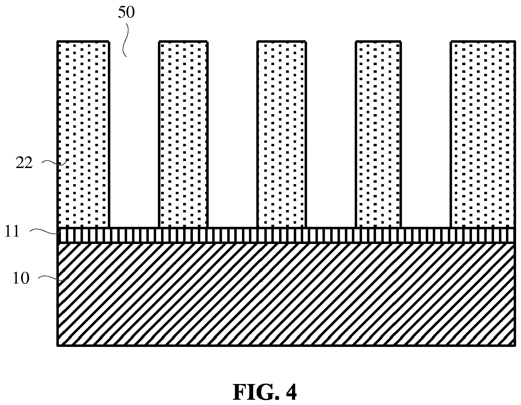

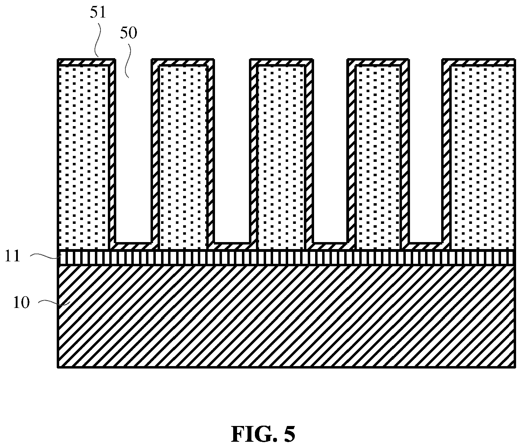

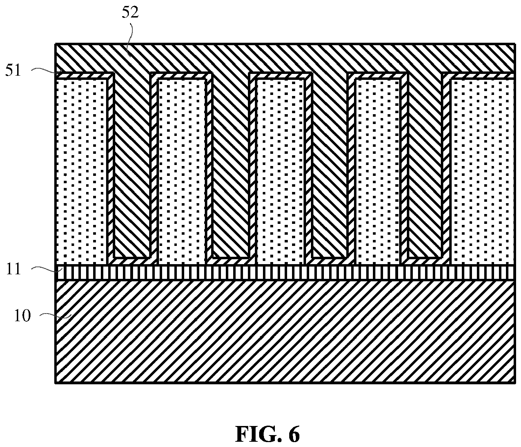

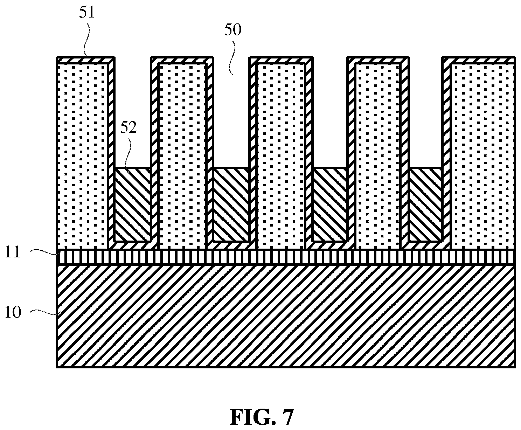

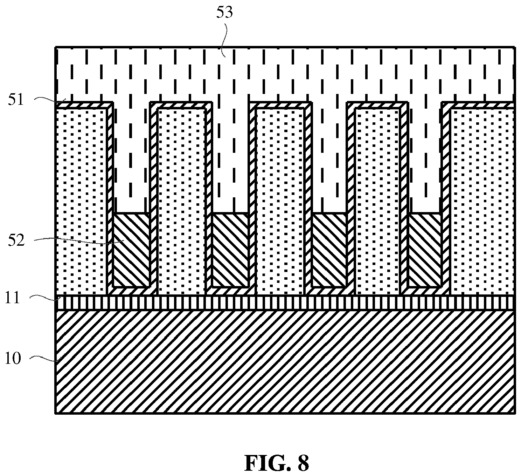

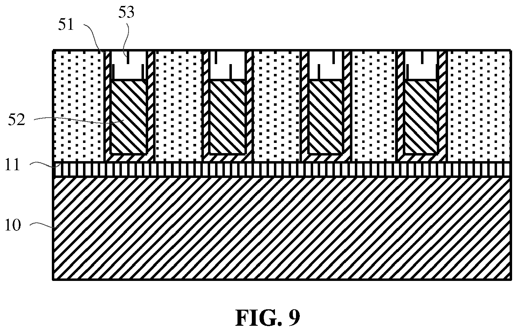

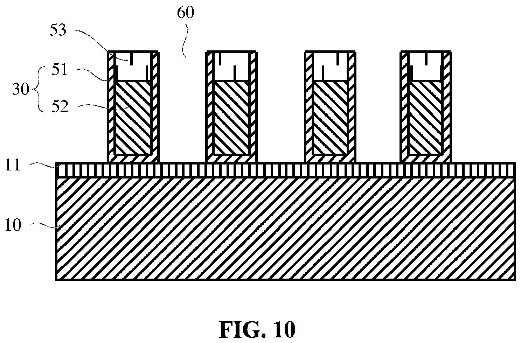

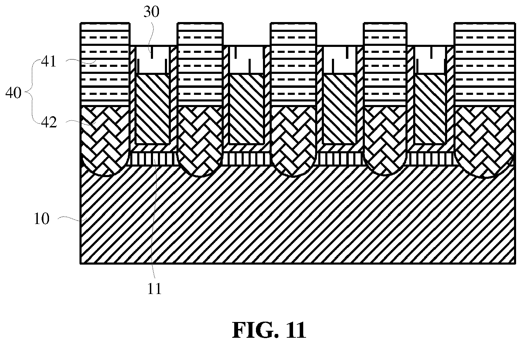

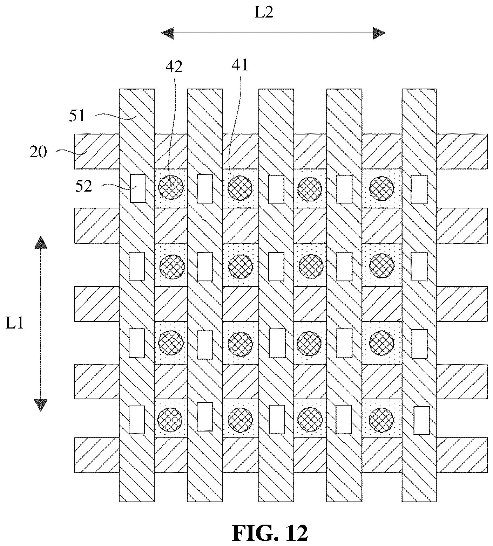

FIG. 2 is a partial three-dimensional structure diagram of a semiconductor device provided by an embodiment of the disclosure. FIG. 3 is a structure diagram of a substrate, an insulating dielectric layer and a sacrificial dielectric layer of a semiconductor device provided by an embodiment of the disclosure. FIG. 4 is a structure diagram of forming a trench on a sacrificial dielectric layer of a semiconductor device provided by an embodiment of the disclosure. FIG. 5 is a structure diagram of forming a first dielectric layer in a trench of a semiconductor device provided by an embodiment of the disclosure. FIG. 6 is a structure diagram of forming a second dielectric layer of a semiconductor device provided by an embodiment of the disclosure. FIG. 7 is a structure diagram of forming a second isolating part of a semiconductor device provided by an embodiment of the disclosure. FIG. 8 is a structure diagram of forming a third dielectric layer of a semiconductor device provided by an embodiment of the disclosure. FIG. 9 is a structure diagram of forming a first isolating part of a semiconductor device provided by an embodiment of the disclosure. FIG. 10 is a structure diagram of forming an opening of a semiconductor device provided by an embodiment of the disclosure. FIG. 11 is a structure diagram of forming a storage node contact structure of a semiconductor device provided by an embodiment of the disclosure. FIG. 12 is a structure diagram of an isolating gate structure of a semiconductor device provided by an embodiment of the disclosure.

As illustrated in FIG. 2 to FIG. 12, an embodiment of the disclosure provides a semiconductor device, which includes: a substrate 10, multiple isolating gate structures 30 and a storage node contact structure 40.

Multiple bit lines 20 are arranged at intervals along a first direction L1 on the substrate 10.

The multiple isolating gate structures 30 are located between the adjacent bit lines 20 and arranged on the substrate 10 at intervals along a second direction L2.

The storage node contact structure 40 is located between the adjacent isolating gate structures 30, and a bottom of the storage node contact structure 40 extends into the substrate 10.

The isolating gate structure 30 includes a first isolating part and a second isolating part, the first isolating part surrounds the second isolating part. A top surface of the first isolating part is not lower than a top surface of the bit line 20.

It is to be noted that the semiconductor device provided by the present embodiment may be a semiconductor memory. Taking a DRAM as example, the DRAM includes an array of multiple memory units arranged on the substrate 10, and each memory unit includes a capacitor and a transistor. The capacitor is configured to store data, and the transistor may control access to data by the capacitor. A grid electrode of the transistor is connected/coupled to a word line (WL), a drain electrode is coupled to the bit line 20, and a source electrode is coupled to the capacitor. A voltage signal on the WL can control the transistor to be on or off, and then data information stored in the capacitor is read through the bit line 20, or the data information is written into the capacitor through the bit line 20 for storage, thereby realizing data access of the DRAM.

The substrate 10 provided by the present embodiment may be monocrystalline silicon, polycrystalline silicon, amorphous silicon, silicon-germanium compound, or silicon-on-insulator (SOI), and the like, or other materials known to the those skilled in the art. The substrate 10 may provide a supporting base for the structural layers on the substrate 10. As illustrated in FIG. 2, the plurality bit lines 20 are arranged on the substrate 10 at intervals along the first direction L1 shown in the figure. Each bit line 20 includes a bit line contact layer, a work function layer covering a top surface of the bit line contact layer, and a bit line layer covering a top surface of the work function layer. In the present embodiment, materials for forming the bit line 20 may include one or a combination of more than two of tungsten, titanium, nickel, aluminum, platinum, titanium dioxide, titanium nitride and doped polysilicon. For example, the material of the work function layer may be titanium nitride, the material of the bit line layer may be tungsten, and the material of a second dielectric layer 52 may be silicon nitride. The spacing between the adjacent bit lines 20 may be set according to needs, which is not limited by the present embodiment.

As illustrated in FIG. 2 and FIG. 11, an isolating gate structure 30 is formed between the adjacent bit lines 20, and the isolating gate structure 30 are arranged between the bit lines 20 along the second direction L2. The second direction L2 may be any direction intersecting with the first direction L1. In the present embodiment, the second direction L2 may be perpendicular to the first direction L1. The storage node contact structure 40 is formed between the isolating gate structures 30. The storage node contact structure 40 may be a capacitor contact hole, that is, a capacitor above the bit line 20 may be coupled to the source electrode or the drain electrode of an active area in the substrate 10 through the storage node contact structure 40. The storage node contact structure 40 may include a connection pad 42 and a contact plug 41 which are laminated. The connection pad 42 may be made of cobalt silicon compound or polysilicon, and the contact plug 41 may be made of tungsten or titanium nitride.

It should be pointed out that the isolating gate structure 30 of the present embodiment includes a first isolating part and a second isolating part, and the first isolating part is located on the periphery of the second isolating part, so that there are at least three layers of isolators between the adjacent storage node contact structures 40. The at least three layers of isolators may include a layer of the second isolating part and two layers of the first isolating part at the left and right sides of the second isolating part. Compared with a layer of isolators of the isolating gate structure 30 in the related art, in the isolating gate structure 30 of the present embodiment, the thickness of multiple layers of isolators increases, and the types of isolators increase, thereby reducing the inductive coupling effect between the adjacent storage node contact structures 40, and meeting the requirement for continuous decrease of the feature size of the DRAM device.

Furthermore, after the feature size of the DRAM device continues to decrease, the spacing between the adjacent bit lines 20 decreases accordingly, therefore, in order to avoid mutual interference of signals between the adjacent bit lines 20, the top surface of the first isolating part in the present embodiment is not lower than the top surface of bit line 20, and the first isolating part is configured to increase the thickness of the isolator between the adjacent bit lines 20, so as to reduce the signal interference between the adjacent bit lines 20, and ensure the stability of signal transmission in the bit line 20.

As illustrated in FIG. 2, there is also an insulating dielectric layer 11 arranged on the substrate 10 of the present embodiment, and a bottom of the second isolating part abuts against the insulating dielectric layer 11. The insulating dielectric layer 11 may effectively isolate the contact between the second isolating part and the substrate 10, thereby avoiding the mutual interference of the structures between the second isolating part and the substrate, and improving the structure stability of the semiconductor device. The insulating dielectric layer 11 may be made of silicon nitride, a composite material of silicon nitride, silicon oxide and silicon nitride, or silicon carbide nitride, or the like.

As illustrated in FIG. 2, the semiconductor device of the present embodiment also includes a bit line isolating layer 21, which is located on a side wall and the top surface of the bit line 20. The bit line isolating layer 21 isolates the bit line 20 and the storage node contact structure 40. Setting like this may use the bit line isolating layer 21 to protect the bit line 20, and at the same time prevent the bit line 20 from being electrically coupled to an adjacent active area contact, which causes short circuit, and ensure the stable signal transmission in the bit line 20.

As an achievable implementation mode, the materials of the insulating dielectric layer 11 and the bit line isolating layer 21 are the same or different. Based on that a bottom of the bit line isolating layer 21 abuts against the insulating dielectric layer 11, if their materials are the same, the types of materials in the semiconductor device may be reduced, thereby reducing the difficulty of preparation, and at the same time improving the connection strength and compatibility at the joint of the insulating dielectric layer 11 and the bit line isolating layer 21. The bit line isolating layer 21 may also be made of silicon nitride, a composite material of silicon nitride, silicon oxide and silicon nitride, or silicon carbide nitride. Of course, the insulating dielectric layer 11 and the bit line isolating layer 21 may also be made of different materials according to the material of the substrate 10 or the bit line 20, so as to ensure the isolating effect of the insulating dielectric layer 11 on the substrate 10 and bit line 20 on the substrate 10, and ensure the isolating effect between the bit line 20 and the adjacent active area contact. The active area contact may be a structural component coupled to the active area of the substrate 10, for example, the storage node contact structure 40 in the present embodiment.

As an achievable implementation mode, the materials of the second isolating part and the insulating dielectric layer 11 are the same or different. It is to be noted that based on that a bottom of the second isolating part abuts against the insulating dielectric layer 11, if their materials are the same, the types of materials in the semiconductor device may also be reduced, thereby reducing the difficulty of preparation. In addition, the connection strength and compatibility at the joint of the second isolating part and the insulating dielectric layer 11 is ensured. Of course, the second isolating part and the insulating dielectric layer 11 may also be made of different materials, so as to ensure the material of the second isolating part according to the requirements of the isolating gate structure 30, and ensure the isolating effect of the isolating gate structure 30 on the signal interference between the adjacent bit lines 20 and on the inductive coupling between the adjacent storage node contact structures 40. At the same time, the material of the insulating dielectric layer 11 may be adjusted according to the material of the substrate 10, so as to ensure the isolating effect of the insulating dielectric layer 11 on the substrate 10 and the bit line 20 on the substrate 10.

As an achievable implementation mode, a bottom of the first isolating part abuts against the insulating dielectric layer 11. It is to be noted that the first isolating part is located on the periphery of the second isolating part and may cover only a side surface and the top surface of the second isolating part, and a bottom surface of the first isolating part does not cover the second isolating part. Setting like this may reduce the complexity of preparation process of the isolating gate structure 30 and improve the structural flexibility of the isolating gate structure 30. At the same time, based on that there is the insulating dielectric layer 11 between the bottom of the first isolating part and the substrate 10, the insulating dielectric layer 11 may effectively isolate the first isolating part and the substrate 10, so as to avoid the mutual effect between the structure and the preparation process of them and thus ensure the structural stability of the semiconductor device.

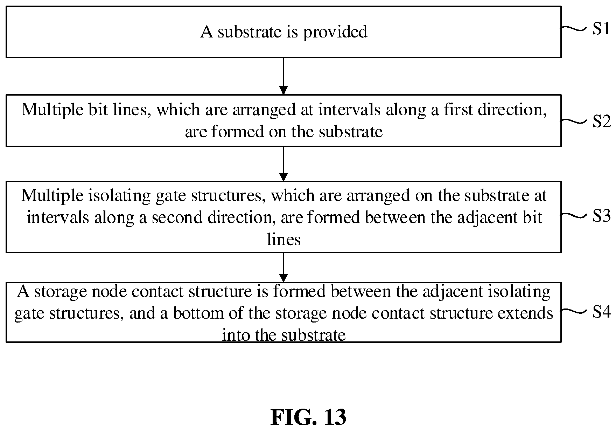

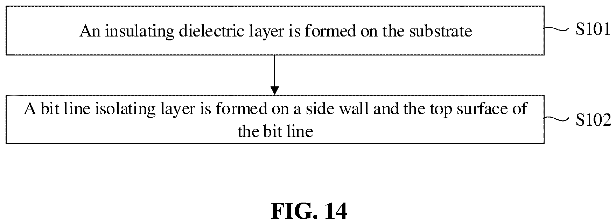

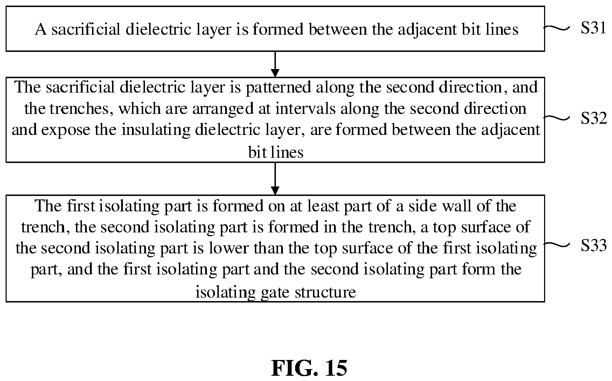

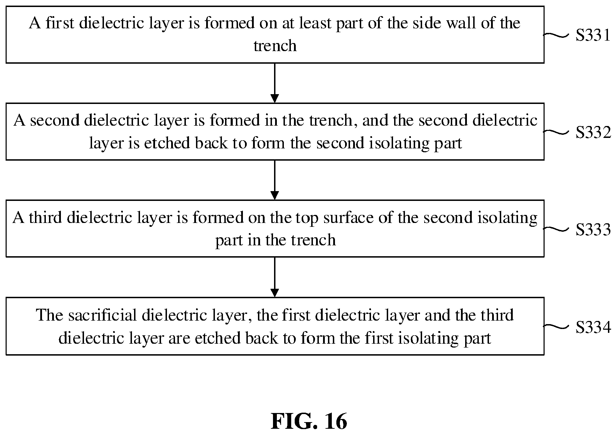

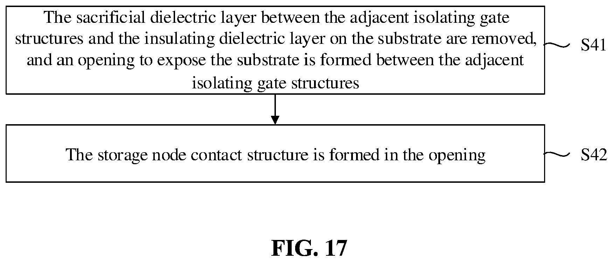

FIG. 13 is a flowchart of a semiconductor device manufacturing method provided by an embodiment of the disclosure. FIG. 14 is a flowchart of forming an insulating dielectric layer and a bit line isolating layer in a semiconductor device manufacturing method provided by an embodiment of the disclosure. FIG. 15 is a flowchart of forming an isolating gate structure in a semiconductor device manufacturing method provided by an embodiment of the disclosure. FIG. 16 is a flowchart of forming a first isolating part and a second isolating part in a semiconductor device manufacturing method provided by an embodiment of the disclosure. FIG. 17 is a flowchart of forming a storage node contact structure in a semiconductor device manufacturing method provided by an embodiment of the disclosure.

On this basis, as illustrated in FIG. 13 to FIG. 17, an embodiment of the disclosure also provides a semiconductor device manufacturing method, which includes the following operations.

At S1, a substrate is provided. The substrate 10 may provide a supporting base for subsequent bit line 20, storage node contact structure, and isolating gate structure 30. Active areas may be arranged on the substrate 10 at intervals. The active areas may be separated by shallow trench isolation (STI). An embedded WL may be formed in the active area, and the bit line 20 interlaced with the WL may be formed on the WL. Of course, an extension direction of the WL may generally be perpendicular to an extension direction of the bit line 20. A grid electrode of the active area may be coupled to the WL, a source electrode (or a drain electrode) of the active area is coupled to the bit line 20, and the drain electrode (or source electrode) of the active area is coupled to a capacitor.

At S2, multiple bit lines, which are arranged at intervals along a first direction, are formed on the substrate. Multiple bit lines 20 are deposited on the substrate 10 through a mask. The multiple bit lines 20 are arranged at intervals along the first direction. In the preparation process of the bit line 20, a line contact layer, a work function layer and a bit line layer may be deposited successively.

At S3, multiple isolating gate structures, which are arranged on the substrate at intervals along a second direction, are formed between the adjacent bit lines. It is to be noted that all the isolating gate structures 30 are located in the area between the adjacent bit lines 20, and there are multiple isolating gate structures 30 in the area between the bit lines 20. The multiple isolating gate structures 30 are arranged at intervals along the second direction L2.

The isolating gate structure 30 of the present embodiment includes a first isolating part and a second isolating part, the first isolating part surrounds the second isolating part, and a top surface of the first isolating part is not lower than a top surface of the bit line 20.

At S4, the storage node contact structure is formed between the adjacent isolating gate structures, and a bottom of the storage node contact structure extends into the substrate. The storage node contact structure 40 is formed between the formed isolating gate structures 30. The storage node contact structure 40 of the present embodiment may be a capacitor contact hole for the connection of the capacitor and the substrate 10.

Specifically, between S1 and S2, that is, before forming multiple bit lines, which are arranged at intervals along the first direction, on the substrate, the method further includes as follows. At S101, an insulating dielectric layer is formed on the substrate. After forming multiple bit lines, which are arranged at intervals along the first direction, on the substrate, and before forming the multiple isolating gate structures, which are arranged on the substrate at intervals along the second direction, between the adjacent bit lines, the method further includes as follows. At S102, a bit line isolating layer is formed on a side wall and the top surface of the bit line.

The insulating dielectric layer 11 is deposited on the substrate 10. The insulating dielectric layer 11 may isolate the substrate 10, the bit line 20 and the isolating gate structure 30, so as to avoid the mutual effect on structure of the bit line 20, the isolating gate structure 30 and the substrate 10.

After the bit line 20 is formed, the bit line isolating layer 21 may be deposited on the side wall or the top surface of the bit line 20. The bit line isolating layer 21 may be either a single-layer structure, namely a silicon nitride layer or a silicon carbide nitride layer, or a composite-layer structure, for example, a composite layer of silicon nitride, silicon oxide and silicon nitride.

Specifically, at S3, that is, the operation that multiple isolating gate structures, which are arranged on the substrate at intervals along the second direction, are formed between the adjacent bit lines, specifically includes as follows.

At S31, a sacrificial dielectric layer is formed between the adjacent bit lines. This operation may correspond to the structure illustrated in FIG. 3, that is, the sacrificial dielectric layer 22 is filled between the adjacent bit lines 20. The sacrificial dielectric layer 22 may be silicon dioxide.

At S32, the sacrificial dielectric layer is patterned along the second direction, and the trenches, which are arranged at intervals along the second direction and expose the insulating dielectric layer, are formed between the adjacent bit lines. This operation may correspond to the structure illustrated in FIG. 4. The trench 50 may be used for the subsequent formation of the isolating gate structure 30. The trench 50 extends downward from a top surface of the sacrificial dielectric layer 22 to a top surface of the insulating dielectric layer 11. The trenches 50 may be arranged at intervals along the second direction L2. The position of the trench 50 determines the position of the rear isolating gate structure 30. The trench 50 may be etched by spacing doubling or other pattern transfer technologies. As an achievable implementation mode, a width range of the trench 50 is 30nm to 50nm, for example, the width of the trench 50 may be 35nm, 40nm, 45nm, or the like. A depth range of the trench 50 is 100 nm to 300nm, for example, the depth of the trench 50 may be 150nm, 200nm, 250nm, or the like.

At S33, the first isolating part is formed on at least part of a side wall of the trench, the second isolating part is formed in the trench, a top surface of the second isolating part is lower than the top surface of the first isolating part, and the first isolating part and the second isolating part form the isolating gate structure.

Specifically, at S33, that is, the operation that the first isolating part is formed on at least part of the side wall of the trench, the second isolating part is formed in the trench, the top surface of the second isolating part is lower than the top surface of the first isolating part, and the first isolating part and the second isolating part form the isolating gate structure, specifically includes as follows.

At S331, a first dielectric layer is formed on at least part of the side wall of the trench. This operation may correspond to the structure illustrated in FIG. 5. The first dielectric layer 51 may be formed on the side wall of the trench 50 by means of atomic layer deposition. A thickness range of the first dielectric layer 51 may be 8nm to 12nm, for example, the thickness of the first dielectric layer 51 may be 9nm, 10nm, 11nm, or the like. The first dielectric layer 51 may be a silicon nitride layer or a silicon carbide nitride layer.

At S332, a second dielectric layer is formed in the trench, and the second dielectric layer is etched back to form the second isolating part. This operation may correspond to the structure illustrated in FIG. 6. The second dielectric layer 52 may also be formed by means of atomic layer deposition. The second dielectric layer 52 fills the trench 50. The second dielectric layer 52 may be a silicon dioxide layer or other materials with low dielectric constant. A thickness range of the second dielectric layer may be 5nm to 20nm, for example, the thickness of the second dielectric layer 52 may be 7nm, 9nm, 11nm, or the like. A part of the second dielectric layer 52 in the trench 50 is removed by means of back etching to form the second isolating part. As the material of the second isolating part is the material with low dielectric constant, when the second isolating part is formed into a part of the isolating gate structure 30, the isolating effect of the isolating gate structure 30 on the inductive coupling effect between the adjacent storage node contact structures 40 can be effectively improved.

At S333, a third dielectric layer is formed on the top surface of the second isolating part in the trench. This operation corresponds to the structure illustrated in FIG. 8. The third dielectric layer 53 may also be formed by means of atomic layer deposition, and may be a silicon nitride layer or a silicon carbide nitride layer. A thickness range of the third dielectric layer may be 28nm to 80nm, for example, the thickness of the third dielectric layer 53 may be 30nm, 50nm, 70nm, or the like. The third dielectric layer 53 fills the trench 50 and covers the top surface of the second isolating part and the surface of the first dielectric layer 51.

At S334, the sacrificial dielectric layer, the first dielectric layer and the third dielectric layer are etched back to form the first isolating part. This operation corresponds to the structure illustrated in FIG. 9. The sacrificial dielectric layer 22, the first dielectric layer 51 and the third dielectric layer 53 may be back etched by means of dry etching, and the remaining first dielectric layer 51 may form the first isolating part. The top surfaces of the remaining sacrificial dielectric layer 22, first dielectric layer 51 and third dielectric layer 53 after etching are flush. The remaining height of the sacrificial dielectric layer 22 may be 160nm. The remaining height of the third dielectric layer 53 is 30nm.

At S4, that is, the operation that the storage node contact structure is formed between the adjacent isolating gate structures, and the bottom of the storage node contact structure extends into the substrate, specifically includes as follows.

At S41, the sacrificial dielectric layer between the adjacent isolating gate structures and the insulating dielectric layer on the substrate are removed, and an opening to expose the substrate is formed between the adjacent isolating gate structures. This operation corresponds to the structure illustrated in FIG. 10. The sacrificial dielectric layer 22 and the insulating dielectric layer 11 may be removed by means of wet etching. The formed opening 60 may be used for form the storage node contact structure 40. As there is the isolating gate structure 30 between the adjacent storage node contact structures, the isolating gate structure 30 can reduce the inductive coupling effect between the adjacent storage node contact structures 40.

At S42, the storage node contact structure is formed in the opening. This operation corresponds to the structure illustrated in FIG. 11. The storage node contact structure 40 may be the capacitor contact hole. A connection pad 42 and a contact plug 41 may be deposited in the opening 60 successively. The connection pad 42 may be coupled to the active are in the substrate 10, so as to ensure that the capacitor contact hole may be coupled to the capacitor and the active area of the substrate 10.

Furthermore, in combination with FIG. 1 and FIG. 12, compared with the isolating gate structure 30 in the related art, in the isolating gate structure 30 provided by the present embodiment, there is also the second dielectric layer 52 arranged in the first dielectric layer 51 between the adjacent bit lines 20, and the first dielectric layer 51 and the second dielectric layer 52 form jointly the isolating gate structure 30. The second dielectric layer 52 may be silicon dioxide with low dielectric constant, so the inductive coupling effect between the adjacent storage node contact structures 40 may be effectively reduced.

It is to be understood in the description that the terms "install", "connected/coupled" and "connect" should be understood generally, unless otherwise expressly stated and qualified, for example, it may be a fixed connection, or an indirect connection through an intermediate medium, or it may be an internal connection of two components or an interaction relationship between two components. For those of ordinary skill in the art, specific meanings of these terms in the disclosure may be understood according to a specific condition. Orientation or position relationships indicated by terms "upper", "lower", "front", "back", "vertical", "horizontal", "top", "bottom", "inner", "outer" and the like are orientation or position relationships illustrated in the accompanying drawings, are adopted not to indicate or imply that indicated devices or components must be in specific orientations or structured and operated in specific orientations but only to conveniently describe the disclosure and simplify descriptions. In the description of the disclosure, "multiple" means two or more than two, unless otherwise specified precisely and specifically.

The specification and claims of the disclosure and terms "first", "second", "third", "fourth", and the like (if existing) in the foregoing drawings are used for distinguishing similar objects rather than describing a specific sequence or a precedence order. It should be understood that the objects may be exchanged under appropriate circumstances, so that the embodiments of the disclosure described here may, for example, be implemented in an order different from that described or shown here. In addition, terms "include" and "have" and any variations thereof are intended to cover non-exclusive inclusions. For example, it is not limited for processes, methods, systems, products or devices containing a series of steps or units to clearly list those steps or units, and other steps or units which are not clearly listed or are inherent to these processes, methods, products or devices may be included instead.

Finally, it is to be noted that the above embodiments are only used for illustrating, but not limiting, the technical solutions of the disclosure.

## Claims

1. A semiconductor device, comprising:
a substrate (10), on which multiple bit lines (20) are arranged at intervals along a first direction;
multiple isolating gate structures (30), which are located between the adjacent bit lines (20) and arranged on the substrate (10) at intervals along a second direction, wherein the isolating gate structure (30) comprises a first isolating part (51) and a second isolating part (52), the first isolating part surrounds the second isolating part, and a top surface of the first isolating part is not lower than a top surface of the bit line (20);
a storage node contact structure (40), which is located between the adjacent isolating gate structures (30), and a bottom of which extends into the substrate (10),
**characterized by** further comprising:
a third dielectric layer (53), formed on a top surface of the second isolating part,
wherein the top surface of the second isolating part is lower than the top surface of the first isolating part, a top surface of the third dielectric layer (53) is flush with the top surface of the first isolating part, and materials of the second isolating part and the third dielectric layer (53) are different.

2. The semiconductor device of claim 1, further comprising: an insulating dielectric layer (11) located on the substrate (10); a bottom of the second isolating part abuts against the insulating dielectric layer (11).

3. The semiconductor device of claim 2, further comprising: a bit line isolating layer (21), which is located on a side wall and the top surface of the bit line (20); wherein the bit line isolating layer (21) isolates the bit line (20) and the storage node contact structure (40).

4. The semiconductor device of claim 3, wherein materials of the insulating dielectric layer (11) and the bit line isolating layer (21) are identical or different.

5. The semiconductor device of claim 2, wherein materials of the second isolating part and the insulating dielectric layer (11) are identical or different.

6. The semiconductor device of claim 2, wherein a bottom of the first isolating part abuts against the insulating dielectric layer (11).

7. A semiconductor device manufacturing method, comprising:
providing (S1) a substrate;
forming (S2) multiple bit lines, which are arranged at intervals along a first direction, on the substrate;
forming (S3) multiple isolating gate structures, which are arranged on the substrate at intervals along a second direction, between the adjacent bit lines; and
forming (S4) a storage node contact structure, a bottom of which extends into the substrate, between the adjacent isolating gate structures;
wherein the isolating gate structure comprises a first isolating part and a second isolating part, and the first isolating part surrounds the second isolating part, and a top surface of the first isolating part is not lower than a top surface of the bit line, **characterized in that**,
a top surface of the second isolating part is lower than the top surface of the first isolating part, a third dielectric layer is formed on the top surface of the second isolating part, a top surface of the third dielectric layer is flush with the top surface of the first isolating part, and materials of the second isolating part and the third dielectric layer are different.

8. The semiconductor device manufacturing method of claim 7, wherein before forming (S2) the multiple bit lines, which are arranged at intervals along the first direction, on the substrate, the method further comprises: forming (S101) an insulating dielectric layer on the substrate; and
wherein after forming (S2) the multiple bit lines, which are arranged at intervals along the first direction, on the substrate, and before forming (S3) the multiple isolating gate structures, which are arranged on the substrate at intervals along the second direction, between the adjacent bit lines, the method further comprises:
forming (S102) a bit line isolating layer on a side wall and the top surface of the bit line.

9. The semiconductor device manufacturing method of claim 8, wherein forming (S3) the multiple isolating gate structures, which are arranged on the substrate at intervals along the second direction, between the adjacent bit lines specifically comprises:
forming (S31) a sacrificial dielectric layer between the adjacent bit lines;
patterning (S32) the sacrificial dielectric layer along the second direction, and forming trenches, which are arranged at intervals along the second direction and expose the insulating dielectric layer, between the adjacent bit lines; and
forming (S33) the first isolating part on at least part of a side wall of the trench, and forming the second isolating part in the trench, the first isolating part and the second isolating part forming the isolating gate structure.

10. The semiconductor device manufacturing method of claim 9, wherein forming (S33) the first isolating part on at least part of the side wall of the trench, and forming the second isolating part in the trench, the first isolating part and the second isolating part forming the isolating gate structure specifically comprises:
forming (S331) a first dielectric layer on at least part of the side wall of the trench;
forming (S332) a second dielectric layer in the trench, and etching back the second dielectric layer to form the second isolating part;
forming (S333) the third dielectric layer on the top surface of the second isolating part in the trench; and
etching (S334) back the sacrificial dielectric layer, the first dielectric layer and the third dielectric layer to form the first isolating part having the top surface flush with the top surface of the third dielectric layer after etching.

11. The semiconductor device manufacturing method of claim 10, wherein forming (S4) the storage node contact structure, the bottom of which extends into the substrate, between the adjacent isolating gate structures specifically comprises:
removing (S41) the sacrificial dielectric layer between the adjacent isolating gate structures and the insulating dielectric layer on the substrate, and forming an opening between the adjacent isolating gate structures to expose the substrate; and
forming (S42) the storage node contact structure in the opening.

## Patentansprüche

1. Halbleitervorrichtung, umfassend:
ein Substrat (10), auf dem mehrere Bitleitungen (20) in Abständen entlang einer ersten Richtung angeordnet sind;
mehrere isolierende Gate-Strukturen (30), die sich zwischen den benachbarten Bitleitungen (20) befinden und auf dem Substrat (10) in Abständen entlang einer zweiten Richtung angeordnet sind, wobei die isolierende Gate-Struktur (30) einen ersten isolierenden Teil (51) und einen zweiten isolierenden Teil (52) umfasst, der erste isolierende Teil den zweiten isolierenden Teil umgibt und eine obere Fläche des ersten isolierenden Teils nicht niedriger ist als eine obere Fläche der Bitleitung (20);
eine Speicherknoten-Kontaktstruktur (40), die sich zwischen den benachbarten isolierenden Gate-Strukturen (30) befindet und deren Boden sich in das Substrat (10) erstreckt,
**dadurch gekennzeichnet, dass** es ferner Folgendes umfasst:
eine dritte dielektrische Schicht (53), die auf einer Oberseite des zweiten isolierenden Teils gebildet ist,
wobei die obere Fläche des zweiten isolierenden Teils niedriger ist als die obere Fläche des ersten isolierenden Teils, eine obere Fläche der dritten dielektrischen Schicht (53) mit der oberen Fläche des ersten isolierenden Teils bündig ist und die Materialien des zweiten isolierenden Teils und der dritten dielektrischen Schicht (53) verschieden sind.

2. Halbleitervorrichtung nach Anspruch 1, ferner umfassend: eine isolierende dielektrische Schicht (11), die sich auf dem Substrat (10) befindet; wobei ein Boden des zweiten isolierenden Teils an der isolierenden dielektrischen Schicht (11) anliegt.

3. Halbleitervorrichtung nach Anspruch 2, ferner umfassend: eine isolierende Bitleitungschicht (21), die sich auf einer Seitenwand und der oberen Oberfläche der Bitleitung (20) befindet; wobei die isolierende Bitleitungschicht (21) die Bitleitung (20) und die Speicherknoten-Kontaktstruktur (40) isoliert.

4. Halbleitervorrichtung nach Anspruch 3, wobei die Materialien der isolierenden dielektrischen Schicht (11) und der isolierenden Bitleitungschicht (21) gleich oder verschieden sind.

5. Halbleitervorrichtung nach Anspruch 2, wobei die Materialien des zweiten isolierenden Teils und der isolierenden dielektrischen Schicht (11) identisch oder verschieden sind.

6. Halbleitervorrichtung nach Anspruch 2, wobei ein Boden des ersten isolierenden Teils an der isolierenden dielektrischen Schicht (11) anliegt.

7. Halbleitervorrichtung-Herstellungsverfahren, umfassend:
Bereitstellen (S1) eines Substrats;
Bilden (S2) mehrerer Bitleitungen auf dem Substrat, die in Abständen entlang einer ersten Richtung angeordnet sind;
Bilden (S3) mehrerer isolierender Gate-Strukturen, die in Abständen entlang einer zweiten Richtung auf dem Substrat zwischen den benachbarten Bitleitungen angeordnet sind; und
Bilden (S4) einer Speicherknoten-Kontaktstruktur, deren Boden sich in das Substrat erstreckt, zwischen den benachbarten isolierenden Gate-Strukturen;
wobei die isolierende Gate-Struktur einen ersten isolierenden Teil und einen zweiten isolierenden Teil umfasst, und der erste isolierende Teil den zweiten isolierenden Teil umgibt, und eine obere Fläche des ersten isolierenden Teils nicht niedriger ist als eine obere Fläche der Bitleitung, **dadurch gekennzeichnet, dass**,
eine obere Fläche des zweiten isolierenden Teils niedriger ist als die obere Fläche des ersten isolierenden Teils, eine dritte dielektrische Schicht auf der oberen Fläche des zweiten isolierenden Teils gebildet ist, eine obere Fläche der dritten dielektrischen Schicht bündig mit der oberen Fläche des ersten isolierenden Teils ist und die Materialien des zweiten isolierenden Teils und der dritten dielektrischen Schicht verschieden sind.

8. Halbleitervorrichtung-Herstellungsverfahren nach Anspruch 7, wobei das Verfahren vor einem Bilden (S2) der mehreren Bitleitungen, die in Intervallen entlang der ersten Richtung auf dem Substrat angeordnet sind, ferner Folgendes umfasst: Bilden (S101) einer isolierenden dielektrischen Schicht auf dem Substrat; und
wobei das Verfahren nach Bilden (S2) der mehreren Bitleitungen, die in Intervallen entlang der ersten Richtung auf dem Substrat angeordnet sind, und vor Bilden (S3) der mehreren isolierenden Gate-Strukturen, die in Intervallen entlang der zweiten Richtung auf dem Substrat angeordnet sind, zwischen den benachbarten Bitleitungen, ferner Folgendes umfasst:
Bilden (S102) einer isolierende Bitleitungschicht auf einer Seitenwand und der oberen Oberfläche der Bitleitung.

9. Halbleitervorrichtung-Herstellungsverfahren nach Anspruch 8, wobei ein Bilden (S3) der mehreren isolierenden Gate-Strukturen, die in Abständen entlang der zweiten Richtung auf dem Substrat angeordnet sind, zwischen den benachbarten Bitleitungen insbesondere Folgendes umfasst:
Bilden (S31) einer dielektrischen Opferschicht zwischen den benachbarten Bitleitungen;
Strukturieren (S32) der dielektrischen Opferschicht entlang der zweiten Richtung und Bilden von Gräben, die in Intervallen entlang der zweiten Richtung angeordnet sind und die isolierende dielektrische Schicht freilegen, zwischen den benachbarten Bitleitungen; und
Bilden (S33) des ersten isolierenden Teils auf mindestens einem Teil einer Seitenwand des Grabens und Bilden des zweiten isolierenden Teils in dem Graben, wobei der erste isolierende Teil und der zweite isolierende Teil die isolierende Torstruktur bilden.

10. Halbleitervorrichtung-Herstellungsverfahren nach Anspruch 9, wobei ein Bilden (S33) des ersten isolierenden Teils auf mindestens einem Teil der Seitenwand des Grabens und ein Bilden des zweiten isolierenden Teils in dem Graben, wobei das erste isolierende Teil und das zweite isolierende Teil die isolierende Gate-Struktur bilden, insbesondere Folgendes umfasst:
Bilden (S331) einer ersten dielektrischen Schicht auf mindestens einem Teil der Seitenwand des Grabens;
Bilden (S332) einer zweiten dielektrischen Schicht in dem Graben und Rückätzen der zweiten dielektrischen Schicht, um den zweiten isolierenden Teil zu bilden;
Bilden (S333) der dritten dielektrischen Schicht auf der Oberseite des zweiten isolierenden Teils in dem Graben; und
Rückätzen (S334) der dielektrischen Opferschicht, der ersten dielektrischen Schicht und der dritten dielektrischen Schicht, um das erste isolierende Teil zu bilden, dessen obere Oberfläche nach Ätzen mit der oberen Oberfläche der dritten dielektrischen Schicht bündig ist.

11. Halbleitervorrichtung-Herstellungsverfahren nach Anspruch 10, wobei ein Bilden (S4) der Speicherknoten-Kontaktstruktur, deren Boden sich in das Substrat erstreckt, zwischen den benachbarten isolierenden Gate-Strukturen insbesondere Folgendes umfasst:
Entfernen (S41) der dielektrischen Opferschicht zwischen den benachbarten isolierenden Gate-Strukturen und der isolierenden dielektrischen Schicht auf dem Substrat und Bilden einer Öffnung zwischen den benachbarten isolierenden Gate-Strukturen, um das Substrat freizulegen; und
Bilden (S42) der Speicherknoten-Kontaktstruktur in der Öffnung.

## Revendications

1. Dispositif à semi-conducteur, comprenant :
un substrat (10), sur lequel plusieurs lignes de bits (20) sont agencées à intervalles dans une première direction ;
plusieurs structures de grille d'isolation (30), qui sont situées entre les lignes de bits (20) adjacentes et agencées sur le substrat (10) à intervalles dans une seconde direction, dans lequel la structure de grille d'isolation (30) comprend une première partie d'isolation (51) et une deuxième partie d'isolation (52), la première partie d'isolation entoure la deuxième partie d'isolation, et une surface supérieure de la première partie d'isolation n'est pas inférieure à une surface supérieure de la ligne de bits (20) ;
une structure de contact de noeud de stockage (40), qui est située entre les structures de grille d'isolation (30) adjacentes, et dont le fond s'étend dans le substrat (10),
**caractérisé en ce qu'**il comprend en outre :
une troisième couche diélectrique (53), formée sur une surface supérieure de la deuxième partie d'isolation,
dans lequel la surface supérieure de la deuxième partie d'isolation est inférieure à la surface supérieure de la première partie d'isolation, une surface supérieure de la troisième couche diélectrique (53) est au même niveau que la surface supérieure de la première partie d'isolation, et les matériaux de la deuxième partie d'isolation et de la troisième couche diélectrique (53) sont différents.

2. Dispositif à semi-conducteur selon la revendication 1, comprenant en outre : une couche diélectrique d'isolation (11) située sur le substrat (10) ; un fond de la deuxième partie d'isolation est en contact avec la couche diélectrique d'isolation (11).

3. Dispositif à semi-conducteur selon la revendication 2, comprenant en outre : une couche d'isolation de ligne de bits (21), qui est située sur une paroi latérale et la surface supérieure de la ligne de bits (20) ; dans lequel la couche d'isolation de ligne de bits (21) isole la ligne de bits (20) et la structure de contact de noeud de stockage (40).

4. Dispositif à semi-conducteur selon la revendication 3, dans lequel les matériaux de la couche diélectrique d'isolation (11) et de la couche d'isolation de ligne de bits (21) sont identiques ou différents.

5. Dispositif à semi-conducteur selon la revendication 2, dans lequel les matériaux de la deuxième partie d'isolation et de la couche diélectrique d'isolation (11) sont identiques ou différents.

6. Dispositif à semi-conducteur selon la revendication 2, dans lequel un fond de la première partie d'isolation est en contact avec la couche diélectrique d'isolation (11).

7. Procédé de fabrication de dispositif à semi-conducteur, comprenant :
la fourniture (S1) d'un substrat ;
la formation (S2) de plusieurs lignes de bits, qui sont agencées à intervalles dans une première direction, sur le substrat ;
la formation (S3) de plusieurs structures de grille d'isolation, qui sont agencées sur le substrat à intervalles dans une seconde direction, entre les lignes de bits adjacentes ; et
la formation (S4) d'une structure de contact de noeud de stockage, dont un fond s'étend dans le substrat, entre les structures de grille d'isolation adjacentes ;
dans lequel la structure de grille d'isolation comprend une première partie d'isolation et une deuxième partie d'isolation, et la première partie d'isolation entoure la deuxième partie d'isolation, et une surface supérieure de la première partie d'isolation n'est pas inférieure à une surface supérieure de la ligne de bits, **caractérisé en ce que**,
une surface supérieure de la deuxième partie d'isolation est inférieure à la surface supérieure de la première partie d'isolation, une troisième couche diélectrique est formée sur la surface supérieure de la deuxième partie d'isolation, une surface supérieure de la troisième couche diélectrique est au même niveau que la surface supérieure de la première partie d'isolation, et les matériaux de la deuxième partie d'isolation et de la troisième couche diélectrique sont différents.

8. Procédé de fabrication d'un dispositif à semi-conducteur selon la revendication 7, dans lequel, avant la formation (S2) des multiples lignes de bits multiples, qui sont agencées à intervalles dans la première direction, sur le substrat, le procédé comprend en outre : la formation (S101) d'une couche diélectrique d'isolation sur le substrat ; et
dans lequel, après la formation (S2) des multiples lignes de bits, qui sont agencées à intervalles dans la première direction, sur le substrat, et avant la formation (S3) des multiples structures de grille d'isolation, qui sont agencées sur le substrat à intervalles dans la seconde direction, entre les lignes de bits adjacentes, le procédé comprend en outre :
la formation (S102) d'une couche d'isolation de ligne de bits sur une paroi latérale et la surface supérieure de la ligne de bits.

9. Procédé de fabrication d'un dispositif à semi-conducteur selon la revendication 8, dans lequel la formation (S3) des multiples structures de grille d'isolation, qui sont agencées sur le substrat à intervalles dans la seconde direction, entre les lignes de bits adjacentes, comprend spécifiquement :
la formation (S31) d'une couche diélectrique sacrificielle entre les lignes de bits adjacentes ;
le modelage (S32) de la couche diélectrique sacrificielle dans la seconde direction, et la formation de tranchées, qui sont agencées à intervalles dans la seconde direction et exposent la couche diélectrique isolante, entre les lignes de bits adjacentes ; et
la formation (S33) de la première partie d'isolation sur au moins une partie d'une paroi latérale de la tranchée, et la formation de la deuxième partie d'isolation dans la tranchée, la première partie d'isolation et la deuxième partie d'isolation formant la structure de grille d'isolation.

10. Procédé de fabrication de dispositif à semi-conducteur selon la revendication 9, dans lequel la formation (S33) de la première partie d'isolation sur au moins une partie de la paroi latérale de la tranchée, et la formation de la deuxième partie isolante dans la tranchée, la première partie d'isolation et la deuxième partie d'isolation formant la structure de grille d'isolation, comprennent spécifiquement :
la formation (S331) d'une première couche diélectrique sur au moins une partie de la paroi latérale de la tranchée ;
la formation (S332) d'une deuxième couche diélectrique dans la tranchée, et la gravure en retrait de la deuxième couche diélectrique pour former la deuxième partie d'isolation ;
la formation (S333) de la troisième couche diélectrique sur la surface supérieure de la deuxième partie d'isolation dans la tranchée ; et
la gravure en retrait (S334) de la couche diélectrique sacrificielle, de la première couche diélectrique et de la troisième couche diélectrique pour former la première partie d'isolation dont la surface supérieure est au même niveau que la surface supérieure de la troisième couche diélectrique après la gravure.

11. Procédé de fabrication de dispositif à semi-conducteur selon la revendication 10, dans lequel la formation (S4) de la structure de contact de noeud de stockage, dont le fond s'étend dans le substrat, entre les structures de grille d'isolation adjacentes comprend spécifiquement :
l'élimination (S41) de la couche diélectrique sacrificielle entre les structures de grille d'isolation adjacentes et la couche diélectrique d'isolation sur le substrat, et la formation d'une ouverture entre les structures de grille d'isolation adjacentes pour exposer le substrat ; et
la formation (S42) de la structure de contact de noeud de stockage dans l'ouverture.
